# EUROPEAN PATENT APPLICATION

(11) **EP 4 520 459 A1**
(43) Date of publication of application: **12.03.2025**
(21) Application number: 23195806.7
(22) Date of filing: 06.09.2023
(51) Int. Cl.: B22F 1/102, B22F 1/145, B22F 1/16, B22F 9/14, B22F 1/054, B22F 9/04

(54) **SYNTHESIS OF CORE/SHELL NANOPARTICLES**

(71) Applicant: Universiteit van Amsterdam, 1012 WX Amsterdam (NL)
(72) Inventor: GRECEA, Stefania, 1012 WX Amsterdam (NL); LUGIER, Olivier Christian Maurice, 1012 WX Amsterdam (NL)
(74) Representative: V.O.

(57) **Abstract**

The invention is in the field of nanoparticles and nanoparticle synthesis. In particular the present invention is directed to a method and a system for producing core/shell nanoparticles, and to core/shell nanoparticles. There is provided a Method for producing core/shell nanoparticles comprising: - producing nanoparticles; - transporting the nanoparticles by a gas stream; - forming one or more shells around the nanoparticles while the nanoparticles are transported by the gas stream.

## Description

### BACKGROUND OF THE INVENTION

The invention is in the field of nanoparticles and nanoparticle synthesis. In particular the present invention is directed to a method and a system for producing core/shell nanoparticles, and to core/shell nanoparticles.

Nanoparticles have gained much interest over the last decades. Due to their small size, nanoparticles have unique properties as compared to larger scale materials, such as micro-scale particles or bulk materials. These properties include large surface-to-volume ratios, as well as unique mechanical, optical and electronic properties. Because of these properties, the usage of nanoparticles is growing in different fields like molecular biology, physics, organic and inorganic chemistry, and material science, for instance for applications in (electro)catalysis, sensors, and energy storage/conversion. Due to their small size, nanoparticles can for instance enter human cells, and are therefore also of interest for (bio)medicinal applications.

Recently, there has also been increased interest in core/shell nanoparticles. Core/shell nanoparticles typically comprise a core located at the center of the particle, surrounded by one or more shells. Core/shell nanoparticles can have a combination of properties and functionalities arising from their core or one or more shells or both. In principle, core/shell nanoparticles can be made from a wide range of materials, including inorganic/inorganic *(i.e.,* an inorganic core with an inorganic shell), inorganic/organic *(i.e.,* an inorganic core with an organic shell), organic/inorganic, and organic/organic materials. Core/shell nanoparticles that comprise at least one inorganic and at least one organic core and/or shell are often referred to as hybrid core/shell nanoparticles.

Typically, the core and the one or more shells are made from different materials with different properties. In this way, core/shell nanoparticles can have different functionalities in one particle. For instance, a shell may act as a protective layer or barrier, enhancing the chemical and/or mechanical stability of the core/shell nanoparticle. Alternatively or additionally, the one or more shells may also have properties that enhance solubility or dispersibility of the core/shell nanoparticle in certain media.

However, although theoretically many types of core/shell nanoparticles can be conceived, it is not always possible to produce these core/shell nanoparticles. Also, even if production of a certain particle is possible, synthesis often involves complex chemical methods which are cumbersome and/or expensive. In addition, using the methods known in the art, it can be difficult to obtain particles of sufficient quality, for instance in terms of purity or particle size distribution. It is typically also challenging to scale-up synthesis methods, making it difficult to prepare core/shell nanoparticles on an industrial scale.

Techniques that are used for the industrial production of regular nanoparticles (*i.e.*, as opposed to core/shell nanoparticles) include mechanical/mechanochemical milling, chemical precipitation, and sol-gel condensation. Adapting these methods for the synthesis of shells around the nanoparticles is not straightforward. If compatible with the more complex structures of core/shell nanoparticles some of these methods can be adapted, or extended (by adding extra processing steps), to enable the production of core/shell nanoparticles. However, adapting synthesis methods is often limited due to chemical compatibility between precursors and requires the use of hardly scalable protocols. Therefore, it is difficult to produce core/shell nanoparticles on a large enough scale for practical applications, and most core/shell nanoparticle synthesis methods remain confined to fundamental research.

Other downsides of these known methods are that extra steps (such as functionalization, purification, oxidation, or steps to allow other chemical reactions to occur) need to be added to the procedure. Especially when some of the steps are performed in solution, extensive purification between different steps may be required.

An object of the present invention is to solve at least one of the above-mentioned difficulties with the synthesis of core/shell nanoparticles.

Another object of the invention is to enable the production of a wide variety of core/shell nanoparticles with a well-defined morphology and/or high purity, preferably with a narrow particle size distribution.

Another object is to provide a system that can be used for convenient synthesis of core/shell nanoparticles.

### BRIEF SUMMARY OF THE INVENTION

In accordance with the present invention there is provided a method for producing core/shell nanoparticles, comprising the steps of: - producing nanoparticles; - transporting the nanoparticles by a gas stream; - forming one or more shells around the nanoparticles while the nanoparticles are transported by the gas stream.

The inventors have found that by forming the one or more shells around the nanoparticles while the nanoparticles are transported by the gas stream, a wide variety of core/shell nanoparticles can be made in high purity, and an even distribution of the one or more shells around the core can be achieved. In addition, core/shell nanoparticles with a narrow size distribution can be formed. Another advantage is that the method is environmentally friendly in the sense that the use of harmful solvents is not necessary, meaning that waste can be reduced. Also, the method can be tuned well to vary the morphology and composition. In addition, the method is less complicated compared to existing multi-step methods and can be scaled up without producing much extra waste.

Moreover, core/shell nanoparticles produced by this technique can be directly incorporated into subsequent process steps, e.g. by depositing them at an electrode surface, for example by impaction, electrostatic precipitation or diffusion. In this way, the core/shell nanoparticles can be directly applied in end products.

There is also provided a core/shell nanoparticle comprising a core surrounded by one or more shells, obtainable by the method as described herein.

Furthermore, there is provided a system for producing core/shell nanoparticles as described herein, comprising a nanoparticle production unit, a collection chamber, and a conduit through which nanoparticles can be transported from the nanoparticle production unit to the collection chamber by a gas flow, the system further comprising one or more inlets for introducing reactive agents and/or vapors into the conduit.

### BRIEF DESCRIPTION OF THE DRAWINGS

Figure 1 is a schematic representation of examples of different core/shell nanoparticles that can be produced.
Figures 2-8 show experimental results for different core/shell nanoparticles.

### DETAILED DESCRIPTION OF THE INVENTION

According to the invention there is provided a method for producing core/shell nanoparticles, comprising the steps of: - producing nanoparticles; - transporting the nanoparticles by a gas stream; - forming one or more shells around the nanoparticles while the nanoparticles are transported by the gas stream.

As used herein, nanoparticle refers to a solid particle having a diameter of less than 500 nm, for instance 1-100 nm. Nanoparticles can either be discrete or agglomerated into clusters. Depending on the size of agglomerated clusters, the agglomerated clusters itself can also be considered to be a nanoparticle. Preferably the nanoparticles are spherical or spheroidal.

The term core/shell nanoparticle refers to a nanoparticle in which the core of the particle has a different chemical composition and/or different properties than one or more shells around that core. Preferably, the one or more shells are continuous, meaning that they cover the entire core or inner shell that they surround, and that the surface of the core or inner shell is not directly exposed to the surrounding atmosphere.

The term hybrid core/shell nanoparticle refers to a nanoparticle having an inorganic as well as an organic component. For instance, a nanoparticle having an inorganic core and at least one organic shell or vice versa is referred to as a hybrid core/shell nanoparticle.

In the method as described herein, forming one or more shells around the core may be performed by chemically reacting the core or a previous shell. This chemical reaction can for instance comprise oxidation, reduction, or nitridation. For example, it is possible to form a metal oxide shell by subjecting a nanoparticle with a metallic surface to an oxidizing agent. Therefore, in embodiments, forming one or more shells comprises introducing a compound that is reactive towards the nanoparticles, into the gas stream. In embodiments, the compound that is reactive towards the nanoparticles is selected from the group consisting of an oxidizing agent, a reducing agent, a radical, and combinations thereof.

Alternatively or additionally, shells can be formed by depositing a layer on the nanoparticles. This can for instance be achieved by introducing one or more vapors into the gas stream. Depending on the chemical composition of the gas stream and the vapors, and depending on the conditions such as temperature and pressure in the gas stream, these vapors can be deposited on the nanoparticles through physical and/or chemical vapor deposition.

Many different vapors can be used for depositing one or more shells. In principle, the vaporizer can be loaded with any solid and/or liquid reagents or solvents that can be vaporized, which offers a high flexibility and a wide range of possibilities for optimization and fine tuning.

For instance, in case an organic shell is to be deposited on a metal core or shell, compounds with functional groups known to coordinate that metal can be used, such as carboxylic acids, silanes, imidazolates, thiols, and/or amines. Deposition of such compounds can lead to hybrid core/shell nanoparticles having an organic layer, for instance an organic monolayer, on their outer surface.

Other vapors that can be introduced in order to form a shell around the nanoparticles are linkers for metal-organic frameworks (MOFs). In that case a MOF shell can be formed around the nanoparticles. In that case, preferably, the reaction conditions are optimized for MOF synthesis. Many applications and development opportunities in a wide range of domains could stem from the production of such nano-scale hybrid materials.

The nanoparticle core is preferably spherical or spheroidal and may have a diameter of 1.0-500 nm, preferably 1.0-100 nm, such as 5-75 nm. Each of the one or more shells may have a thickness ranging from less than 1.0 nm, which can for instance be the thickness of an organic monolayer, to 100 nm. Preferably, each shell has a thickness of less than 1.0 nm to 50 nm.

After forming the one or more shells around the nanoparticle, the core/shell nanoparticles can be collected from the gas stream. Preferred options for collection of the core/shell nanoparticles include filtration, and/or deposition of the core/shell nanoparticles on a substrate. Alternatively or additionally, the core/shell nanoparticles may be collected from the gas stream by bubbling the gas stream in a solvent, thereby forming a dispersion of core/shell nanoparticles.

The nanoparticles can advantageously be produced by spark ablation. Spark ablation is a physical phenomenon whereby a spark between two electrodes is generated, leading to local ablation of the electrodes. By this ablation, a vapor of the matter comprised by the electrodes is obtained, which is subsequently rapidly cooled. This vapor initially comprises mainly single atoms, which collide and grow in time to larger particles comprising multiple atoms, in a process described as coagulation. The size to which particles grow by this mechanism depends mostly on the initial vapor concentration and the time allowed for growth. By approximation, the mean particle mass *m* at a certain time can be calculated by dividing the initial vapor mass concentration C by the particle number concentration *N* at time *t.* From coagulation theory, which is assumed to apply to the present invention, it follows that the particle number concentration essentially decreases proportional to 1/t, so that *m* = *C*/*N,* which is proportional to *C*×*t.* By working with short process times, small particle masses, and thus small particle sizes, can be obtained, while keeping the concentration high. High particle concentrations result in larger production rates, and a faster, more efficient production of nanoparticles. The production of nanomaterials by spark ablation is for instance described in WO2016080837, the contents of which are incorporated herein by reference. An advantage of producing the nanoparticles by spark ablation is that in this process, nanoparticles are formed in the gas stream, making this way of production especially suitable with the step of forming one or more shells around the nanoparticles while the nanoparticles are transported by the gas stream. Because of that, there is less chance of agglomeration of the nanoparticles before the one or more shells are formed, leading to a more even distribution of the one or more shells around the core, and a more narrow particle size distribution.

In the spark ablation process, an electrical discharge between two electrodes comprising conductive (or semi-conductive) materials forms a short-lived plasma that reaches temperatures well above the boiling point of the material and creates a metallic vapor cloud. While cooling down, the metal condenses to form a nanoparticles aerosol that is then carried away by an gas stream. Preferably, the carrier gas stream is inert vis-à-vis the nanoparticles that are formed from the vapor cloud. Once the nanoparticles have been formed, shells can be formed around the nanoparticles to produce core/shell nanoparticles.

When the (core of the) nanoparticles are produced using spark ablation, the nanoparticles that are transported in the gas stream and that are produced from the spark may be charged, increasing the likelihood of surface reactions and/or deposition of a shell around the nanoparticle.

In spark ablation, the size of the resulting nanoparticles depends on the initial concentration of evaporated material which is itself proportional the energy of the spark (*i.e.*, the breakdown voltage of the discharge) and inversely proportional to the flow rate of the carrier gas. Therefore, the size of the nanoparticles can easily be tuned.

However, it is also possible to perform the process with nanoparticles that have been produced in a different way than by spark ablation, such as mechanical/mechanochemical milling, chemical precipitation, and sol-gel condensation, and bringing these nanoparticles in a carrier gas flow.

Advantageously, the method as described herein can be performed at atmospheric pressures, and it is generally not necessary to operate at vacuum conditions. The pressure at which the shells are formed around the nanoparticle can be varied depending on the type of process (e.g., chemical reaction with the nanoparticle, physical vapor deposition, or chemical vapor deposition). Preferably, the absolute pressure during forming the one or more shells is 0.25-2.5 bar, more preferably 0.5-2 bar, even more preferably 0.8-1.7 bar, such as 0.9-1.4 bar.

Preferably, before formation of the one or more shells, the nanoparticles are metallic nanoparticles. Metallic nanoparticles may have favorable properties in terms of conductivity and mechanical strength, and in some cases also favorable optical and magnetic properties. Moreover, metallic nanoparticles can be readily made from a wide range of different metals, for instance using spark ablation. Alternatively, before formation of the one or more shells, the nanoparticles may also be carbon nanoparticles, which can for instance also be produced using spark ablation. In case the nanoparticles before formation of the one or more shells is metallic, the metal is preferably selected from the group consisting of zinc, iron, nickel, gold, aluminum, silver, platinum, and iridium.

According to a second aspect, there is provided a core/shell nanoparticle comprising a core surrounded by one or more shells, obtainable by the method described herein.

In embodiments, the core of the core/shell nanoparticle is metallic, and at least one of the one or more shells, preferably the shell directly adjacent the core is a metal oxide. In that case, preferably, the metal of the core is selected from zinc, iron, nickel, gold, aluminum, and silver.

In embodiments, the core and/or one of the shell comprises organic material. For instance, the shell can comprise one or more polymers. Examples of suitable polymers include biopolymers, cellulose polymers, polymeric systems for drug delivery (such as arginine, chitosan, dextran, poly(ethylenimine)), or biomolecules such as amino acids, proteins, polysaccharides, or polyalcohols. In embodiments, at least one of the one or more shells comprises a metal-organic framework.

Many variations of the above-mentioned embodiments are possible, for instance a metallic core surrounded by a metal oxide shell, surrounded by an organic shell. An advantage of surrounding a metallic core with a metal oxide shell is that the metal oxide shell may improve reactivity of the nanoparticle towards grafting reactions of organic vapors relative to a metallic core. For instance, the hydroxyl groups that can be present in a metal oxide shell may enable acid-base reactions leading to functionalisation of silanes and/or dehydration reactions leading to the coordination of carboxylates.

In embodiments, the core/shell nanoparticle is a hybrid core/shell nanoparticle.

In embodiments, the core/shell nanoparticle comprises a metallic core surrounded by a metal oxide shell.

In embodiments, the core/shell nanoparticle comprises a metallic core surrounded by a first metal oxide shell, surrounded by a second organic shell.

The second organic shell may for instance comprise one or more selected from the group consisting of a carboxylate, a silane, and a metal-organic framework.

In case the core/shell nanoparticle comprises a metallic core, a metal oxide shell and/or a shell comprising a metal-organic framework, the metals in the core and the respective shells may be the same and/or different metals.

In embodiments, the core/shell nanoparticle comprises a metallic core, surrounded by a metal oxide shell, surrounded by a shell comprising a metal-organic framework, wherein the metal in the core and in the shells is the same.

In embodiments, the core/shell nanoparticle has a metallic zinc core, surrounded by a first shell comprising zinc oxide, surrounded by a second shell comprising a zinc-containing metal-organic framework, such as ZIF-8.

In case one of the one or more shell comprises a metal-organic framework, the metal-organic framework may be crystalline and/or amorphous. In preferred embodiments, the metal-organic framework is amorphous.

As explained above, the method of the invention can lead to core/shell nanoparticles having a well-defined morphology, such as well-controlled shape, shell thickness and/or particle size. Therefore, there is provided a plurality of core/shell nanoparticles as described above, wherein the core/shell nanoparticles are spherical or spheroidal.

Preferably, the core/shell nanoparticles have an average particle diameter of 1-100 nm, preferably 5-100 nm with a standard deviation of 20% or less, preferably 10% or less, more preferably 8% or less, such as 5% or less.

Core/shell nanoparticles according to the invention can be used for a wide variety of applications. By way of example, zinc-based materials for biomedical applications can be produced, but it will be appreciated that many different materials and core/shell combinations are possible. Zinc oxide is considered as low toxic and is approved by the FDA for cosmetic preparations. However, for application in drug delivery, there are concerns due to its metallic nature and the potentially harmful effects of ZnO nanoparticles to body cells. This risk can be reduced by functionalizing their surface with organic groups (*i.e.,* providing an organic shell around the nanoparticles). Currently, the synthesis of such core/shell nanoparticles for biomedical applications is limited to bottom-up approaches relying on the assembly of chemically synthesized nanoscale building-blocks. These methods are liquid-phase methods in aqueous or non-aqueous media, requiring multi-step synthetic procedures where a variety of physical and chemical parameters have to be finely tuned. The fact that such zinc-based hybrid core/shell nanoparticles are currently synthesized in liquid phase gives rise to uncertainty regarding the influence of contaminating species like surfactants or solvents. Contrarily, when using the method of the invention, core/shell nanoparticles are produced in a very controlled manner and in the absence of solvents and contaminants. In this way, core/shell nanoparticles that comply with strict medical regulations can be made.

Core/shell nanoparticles according to the invention, such as metallic particles with an organic shell, may be used in medical imaging and/or therapy. The organic phase of hybrid core/shell nanoparticles can improve stability *in vivo* and enable cell or tissue targeting.

The core/shell nanoparticles according to the invention could also be used in other technologies, such as chemical sensing, as well as energy storage and/or conversion. There is also provided a system suitable for producing core/shell nanoparticles, preferably using the method as described above, comprising a nanoparticle production unit, a collection chamber, and a conduit through which nanoparticles can be transported from the nanoparticle production unit to the collection chamber by a gas flow. In order to form the one or more shells around the nanoparticle, the system may further comprise one or more inlets for introducing reactive agents and/or vapors into the conduit.

Preferably, the nanoparticle production unit is a spark ablation generator.

The conduit may for instance be a tube into which the reactive agents and/or vapors are introduced. The conduit may also comprise a mixing chamber in which the conditions for forming the shells, such as temperature and pressure, can be controlled.

The use of the terms "a" and "an" and "the" and similar referents in the context of describing the invention (especially in the context of the following claims) are to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventor for carrying out the invention. Variations of those preferred embodiments may become apparent to those of ordinary skill in the art upon reading the foregoing description. The inventor expects skilled artisans to employ such variations as appropriate, and the inventor intends for the invention to be practiced otherwise than as specifically described herein. Accordingly, this invention includes all modifications and equivalents of the subject matter recited in the claims appended hereto as permitted by applicable law. Moreover, any combination of the above-described elements in all possible variations thereof is encompassed by the invention unless otherwise indicated herein or otherwise clearly contradicted by context.

While the invention has been described with respect to specific examples including presently preferred modes of carrying out the invention, those skilled in the art will appreciate that there are numerous variations and permutations of the above described systems and techniques that fall within the spirit and scope of the invention as set forth in the appended claims.

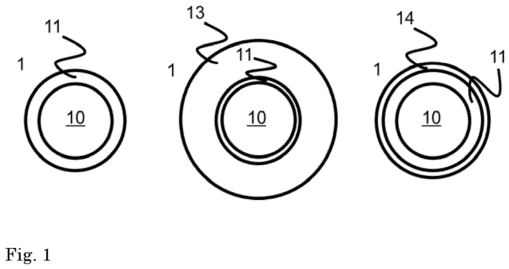

Figure 1 is a schematic representation of possible core/shell nanoparticles.

Core/shell nanoparticle (1) comprises core (10) and one or more shells (11, 13, 14). Core (10) can for instance be a metallic core or a carbon core, but other core materials are also possible. First shell (11) can for instance comprise a metal oxide. In embodiments, first shell (11) may for instance be the metal oxide corresponding to the metal of core (10) in case core (10) is metallic. Further shells (13, 14) are for instance organic. The thickness of such shells may depend on the chemical nature and/or the way the shell is applied. For instance, a MOF layer may be a relatively thick layer (13) compared to an thinner monolayer (14), such as a carboxylate or a silane monolayer.

### EXAMPLES

Different core/shell nanoparticles were synthesized and analyzed. In the examples below, nanoparticles were generated using the VSP-G1 spark ablation generator from VSPARTICLE, using zinc electrodes. Different types of shells were formed around the nanoparticles. The resulting core/shell nanoparticles were characterized using PXRD, ATR, SEM/STEM and TGA/DSC.

If not specified otherwise, all chemicals were purchased from commercial suppliers and used without further purification. The Zn electrodes were obtained from VSPARTICLE along with the VSP-G1.

Powder X-ray diffraction (PXRD) patterns were measured using a Rigaku MiniFlex II diffractometer with a scanning speed of 2.5°/min using Cu K-alpha radiation (λ = 1.5406 Å).

Fourier-transform infrared spectroscopy (FTIR) was carried out on a Thermo Fisher Scientific Nicolet iS50 FTIR spectrometer equipped with a Specac Quest ATR accessory.

Thermogravimetric analysis and differential scanning calorimetry (TGA-DSC) were performed using a NETZSCH Jupiter STA 449F3 instrument at a heating rate of 5 K/min under Argon atmosphere.

Scanning electron microscopy (SEM) was carried out using a FEI Verios 460, typical electron energy was 5 KeV and current 100 nA.

Scanning transmission electron microscopy (STEM) images were obtained using a HAADF (High Angle Angular Dark Field) detector and the energy dispersive spectroscopy (EDS) data was obtained with an Oxford Xmax 80 mm² silicon drift detector. Both detectors were mounted on the aforementioned FEI Verios 460.

TEM images were obtained using a FEI TecnaiG2 20 X-Twin. The samples were either directly deposited or drop casted from ethanolic dispersions on TEM grids (Formvar / Carbon on 300 mesh from Ted Pella Inc.)

### Example 1 - Zn/ZnO nanoparticles.

Core/shell nanoparticles with a zinc core surrounded by a zinc oxide shell (Zn/ZnO nanoparticles) were synthesized. The core was made using spark ablation using the VSP-G1 (VSPARTICLE) under a nitrogen flow (2 L/min) as carrier gas. Typically, 1.2 kV and 8 mA were used to generate the spark. Small amounts of air and/or water in the system served as a source of oxygen downstream of the spark ablation.

After forming the zinc oxide shell, the nanoparticles were collected, either on a filter paper (ø 47 mm), or on a 1 cm × 1 cm silicon substrate, placed in the filtration unit of the VSP-G1. Products were collected after 10 to 24h of synthesis.

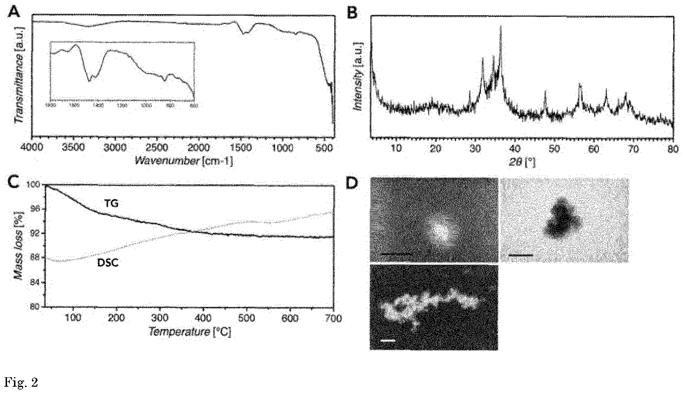

An ATR-IR spectrum, PXRD pattern, TGA/DSC curve and SEM/STEM images are shown in figure 2. The ATR-IR shows characteristic OH stretching vibrations of the hydroxyl groups on their surface with a wide band around 3400 cm⁻¹ and a doublet between 1250 cm⁻¹ and 1500 cm⁻¹. The typical Zn-O stretching vibration can be seen in the 600-400 cm⁻¹ range. PXRD shows that the nanoparticles are mainly composed of ZnO with a small amount of metallic Zn. The peaks at 31.8°, 34.5°, 36.2°, 47.6°, 56.6°, 62.9° and 68.0°, correspond to the (100), (002), (101), (102), (110), (103) and (112) crystalline planes of Wurtzite, respectively. The metallic phase is evidenced by weaker peaks at 35.4°, 43.3° and 53.0° that correspond to the (002), (101) and (102) crystalline planes, respectively.

TGA-DSC shows that the core/shell nanoparticles lose 8.7% of their mass in the low temperature range, likely caused by the desorption of water or solvents molecules, and then remain stable until 700 °C.

### Example 2 - hybrid Zn/ZnO nanoparticles with a molecular shell coordinated via carboxylic acid groups.

Carboxylates can coordinate metal oxides (e.g., zinc oxide, nickel oxide). Although usually weakly bonded, carboxylates can form a monolayer (*i.e.,* a 2D shell) on metal oxide surfaces, significantly changing the properties of the functionalized material.

Nanoparticles with two different types of carboxylate-bonded molecular shell: citric acid (CA) and 2-naphthoic acid (NA), were also synthesized. The synthesis was the same as example 1, except that vapor of either of the two aforementioned molecules was introduced instead.

The carboxylic acid molecules were placed in the vaporizer and heated up to 125 °C under a flow of nitrogen (0.5 L/min) while Zn/ZnO nanoparticles were produced by the VSP-G1 using the conditions described above.

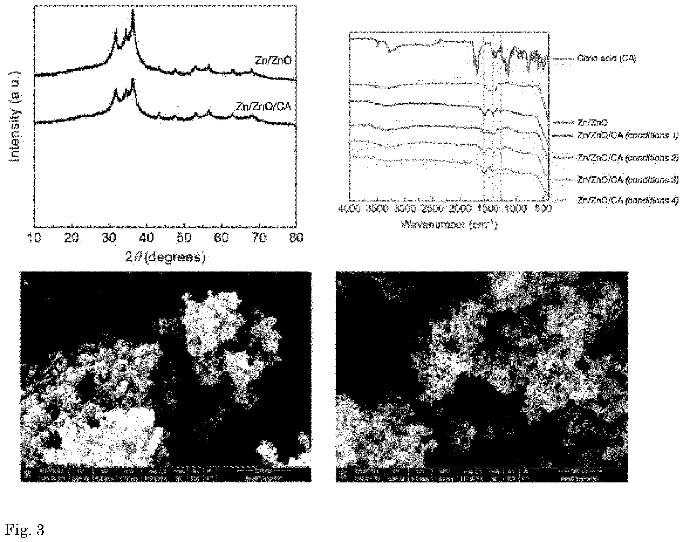

Figure 3 shows PXRD patterns, ATR-IR spectra and SEM images of nanoparticles with a citric acid shell.

As expected because citric acid is only present as a monolayer, the PXRD patterns and SEM images are similar to those of the Zn/ZnO nanoparticles.

Infrared spectroscopy confirms the presence of coordinated citrate on the NPs. Vibrational bands at 1565, 1410, 1270 cm⁻¹, attributed to the COO- asymmetric stretching, symmetric stretching and bending vibrations, respectively, are observed. In addition, the lack of a C=O stretching band at 1700 cm⁻¹ suggests that the three carboxylic acid groups of the linker are deprotonated, and thus coordinated.

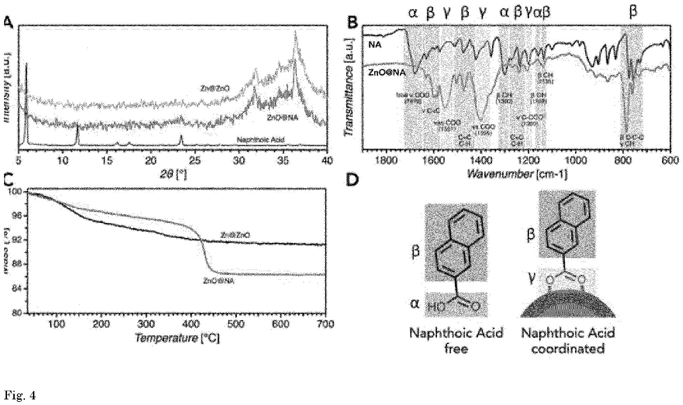

Figure 4 shows a PXRD pattern, ATR-IR spectrum, TGA/DSC curve and a schematic view of the nanoparticles with a naphthoic acid shell.

Similarly to citric acid, the PXRD pattern is not significantly different from that of the Zn/ZnO nanoparticles.

IR analysis reveals that all OH-related bands (1300 cm⁻¹, 1159 cm⁻¹) disappear while the bands assigned to the carboxyl group and CC or CH bonds are shifted. In addition, the nanoparticles with a NA shell do not show any free carboxylate band around 1700 cm⁻¹, confirming that the organic phase is composed of a unique layer of molecules coordinated *via* their carboxylate group. The asymmetric and symmetric stretching vibration of COO- are observed at -1550 cm⁻¹ and ~ 1400 cm⁻¹ (overlapping with CC and CH related vibrations).

The concave shape of the TG curve during the loss of water and other solvent at low temperatures (< 250 °C) suggest a hydrophobic surface, as expected from an aromatic monolayer. This first desorption event accounts for 3.4 % of the total sample mass. The desorption of the naphthoic acid molecules happens between 250 °C and 550 °C. The sharp weight loss of 9.1 % at *ca.* 425 °C corresponds to the main desorption event during which the coordinated molecules are lost. After that, the increasing temperature does not trigger any further mass loss until 700 °C. The intense endothermic peak at 430 °C in the DSC signal corresponds to evaporation of naphthoic acid which occurs at higher temperature than the boiling point of the non-coordinated linker (300°C).

### Example 3 - hybrid Zn/ZnO nanoparticles with an APTES shell.

Nanoparticles with an organic (3-aminopropyl)triethoxysilane (APTES) shell were also synthesized. The synthesis was the same as example 2, except that APTES vapor was introduced instead.

The APTES was placed in the vaporizer and heated up to 80 °C under a flow of nitrogen (0.5 L/min) while Zn/ZnO nanoparticles were produced by the VSP-G1 using the conditions described above.

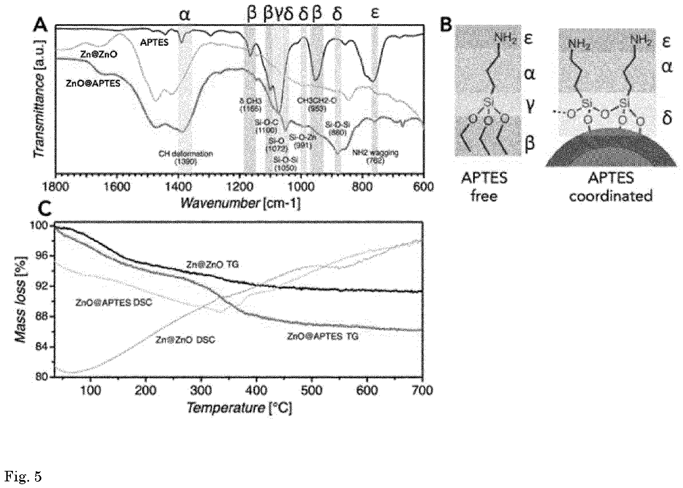

Figure 5 shows a ATR-IR spectrum, a schematic view, and a TGA/DSC curve of the nanoparticles with an APTES shell.

ATR-IR confirms the successful anchoring of the silanes at the surface. The spectra shows that the bands related to the CH₃CH₂O functional groups (1165 cm⁻¹, 1100 cm⁻¹, 953 cm⁻¹) disappeared as expected upon grafting. In addition, multiple vibrational bands assigned to the NH and CH bonds of the molecules (1645 cm⁻¹, 1390 cm⁻¹, 762 cm⁻¹) are observed. The two intense bands (1100 cm⁻¹ and 880 cm⁻¹) are attributed to vibrational modes of Si-O-Si groups. Also, the CH stretching vibrations of the APTES backbone are visible at 2975 cm⁻¹, 2930 cm⁻¹ and 2887 cm⁻¹ Finally, the clear Si-O-Si vibrational band observed at 1050 cm⁻¹ indicates that a least some of the APTES on the surface underwent cross polymerisation with their neighbouring molecules.

The TGA data show the nanoparticles lose 6.3% of their mass in the low temperature range (35 - 250 °C) from water and/or solvent desorption, and 7.1% of their mass from 250 °C onwards. The main desorption event (*i.e.,* the loss of the organic phase) takes place around 350 °C. Considering that the boiling point of pristine APTES is 217 °C, these observations further confirm our conclusions from IR analysis.

The multiple endothermic peaks observed on the DSC curve (335 °C, 368 °C and 428 °C) during the desorption of the organic phase signals a multi-step process. Multi-step desorption can stem from inhomogeneities in the APTES-substrate binding and/or from cross polymerization, further supporting the aforementioned interpretation of the IR data.

### Example 4 - hybrid ZnO nanoparticles with a MOF shell.

Nanoparticles with a zeolitic imidazolate framework (ZIF-8) shell were also synthesized. The synthesis was the same as example 2 and 3, except that 2-methylimidazole vapor was introduced instead.

The 2-methylimidazole was placed in the vaporizer and heated up to 100 °C under a flow of nitrogen (0.5 L/min) while Zn/ZnO nanoparticles were produced by the VSP-G1 using the conditions described above. Products were collected after 10h to 24h of synthesis.

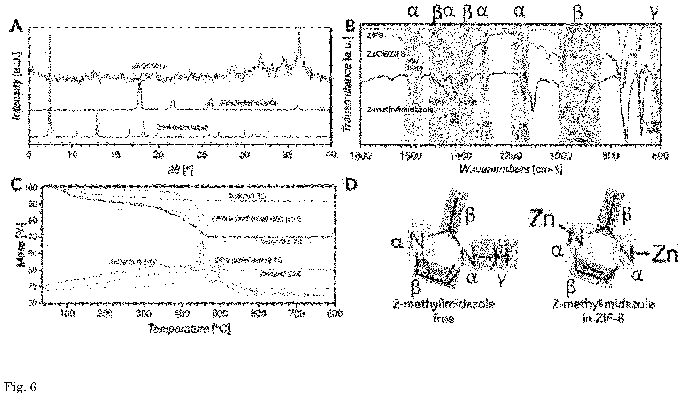

Figure 6 shows a PXRD pattern, an ATR-IR spectrum, a TGA/DSC curve, and a schematic view of the nanoparticles with a ZIF-8 shell.

In the PXRD pattern, the nanoparticles obtained from the synthesis with vapours of ZIF-8 linkers (2-methylimidazole) do not show any clear peak related to one of the ZIF-8 crystalline phases (e.g., sodalite, katsenite or diamonite). Nevertheless, the baseline of the diffractogram is not straight in the region of interest for ZIF-8 (6° to 28°) and some bumps are visible in the noise at relevant angles.

Although amorphous, the infrared analysis of the nanoparticles synthesised in the presence of 2-methylimidazole vapors in the system confirms the formation of ZIF-8. The CN and CH vibrations indicate that 2-methylimidazole molecules are present in the sample, while the disappearance of NH vibrational bands (bending at 620 cm⁻¹ and 1595 cm⁻¹; stretching at 2200-3100 cm⁻¹) and the frequency shifts of the CN vibrations support the hypothesis of the coordination of the linkers. The strong Zn-N stretching vibration (420 cm⁻¹), clearly visible despite overlapping the wide Zn-O stretching band, is another argument supporting the presence of an amorphous layer of ZIF-8 encapsulating the Zn/ZnO nanoparticles.

The TGA data show the nanoparticles lost 9.7% of their mass in the lower temperature range (35 - 250 °C) from moisture and/or solvent desorption, like with the Zn/ZnO nanoparticles. In the second temperature range (250 °C to 550 °C), the nanoparticles lose 20.0% of their weight, due to collapse of the ZIF-8 framework structure. At 700 °C, most of the organic phase is lost, with 69.4% of the initial mass remaining.

DSC analysis shows a sharp exothermic peak at 450 °C, related to the initial collapse of the ZIF-8 framework.

### Example 5 -Fe/FeₓO_{y} nanoparticles.

Core/shell nanoparticles with a iron core surrounded by a iron oxide shell (Fe/FeₓO_{y} nanoparticles) were synthesized. The synthesis was the same as example 1, except that iron electrodes were used instead.

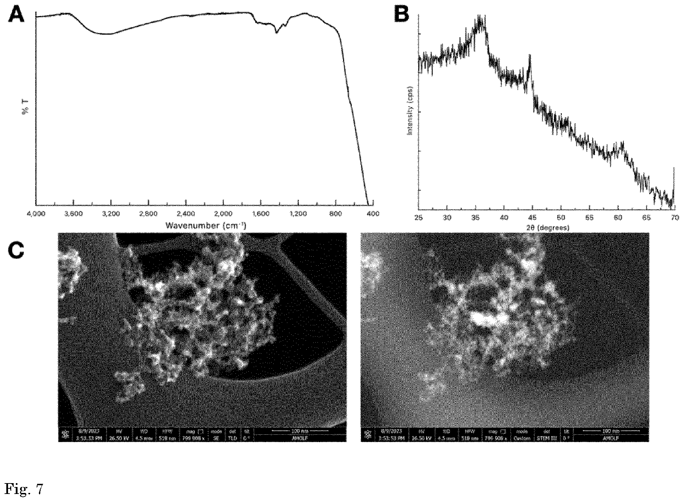

Figure 7 shows a ATR-IR spectrum, a PXRD spectrum, and SEM/STEM images of the Fe/FeₓO_{y} nanoparticles.

The ATR-IR shows characteristic OH stretching vibrations of the hydroxyl groups on their surface with a wide band around 3370 cm⁻¹ (between 3000 and 3600 cm-1) and at 1631 cm⁻¹. The typical Fe-O stretching vibration can be seen in the 600-400 cm⁻¹ range.

PXRD shows that the nanoparticles are composed of Fe(0) and FeₓO_{y}. The metallic phase is evidenced by the sharper peak at 44.7° that corresponds to the (110) crystalline plane. The peaks at 36.0° and 61.0° are close to the theoretical positions of peaks characteristic of maghemite (γ-Fe₂O₃) and magnetite (Fe₃O₄). The broadness of the sample's peaks is likely due to both phases being present and their peaks (maghemite: 57.5° and 63.2°; magnetite: 62.4°) overlapping.

### Example 6 - hybrid Fe/FeₓO_{y} nanoparticles with an APTES shell.

Nanoparticles with an organic (3-aminopropyl)triethoxysilane (APTES) shell were also synthesized. The synthesis was the same as example 3, except that iron electrodes were used instead.

The APTES was placed in the vaporizer and heated up to 80 °C under a flow of nitrogen (0.5 L/min) while Fe/FeₓO_{y} nanoparticles were produced by the VSP-G1 using the conditions described above in example 5.

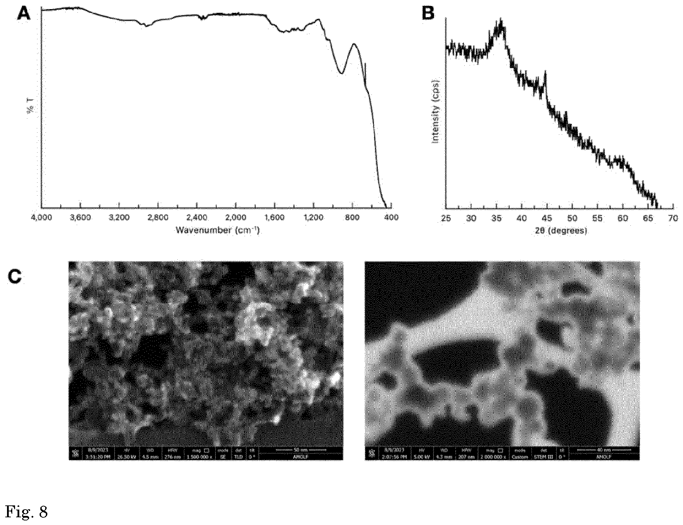

Figure 8 shows a ATR-IR spectrum, a PXRD spectrum, and SEM/STEM images of the Fe/FeₓO_{y} nanoparticles with an APTES shell.

As expected because APTES is only present as a monolayer, the PXRD patterns are similar to those of the Fe/FeₓO_{y} nanoparticles.

ATR-IR confirms the successful anchoring of the silanes at the surface. The spectra shows that the bands related to the CH₃CH₂O functional groups (1165 cm⁻¹, 1100 cm⁻¹, 953 cm⁻¹) are significantly less intense, as expected upon grafting. In addition, multiple vibrational bands assigned to the NH and CH bonds of the molecules (1645 cm⁻¹, 1390 cm⁻¹) are observed. The intense band attributed to vibrational modes of Si-O-Si and Si-O-Fe groups (~ 900 cm⁻¹) indicates that a least some of the APTES on the surface underwent cross polymerisation with neighbouring molecules. Also, the CH stretching vibrations of the APTES backbone are visible at 2975 cm⁻¹, 2930 cm⁻¹ and 2887 cm⁻¹.

## Claims

1. Method for producing core/shell nanoparticles comprising:
- producing nanoparticles;
- transporting the nanoparticles by a gas stream;
- forming one or more shells around the nanoparticles while the nanoparticles are transported by the gas stream.

2. Method according to claim 1, wherein forming one or more shells around the nanoparticles comprises introducing a compound that is reactive towards the nanoparticles, preferably an oxidizing agent, into the gas stream.

3. Method according to claim 1 or 2, wherein forming one or more shells around the nanoparticles comprises depositing a layer on the nanoparticles by introducing one or more vapors into the gas stream.

4. Method according to any one of the preceding claims, followed by collecting the core/shell nanoparticles, preferably by filtration of the gas stream comprising the core/shell nanoparticles.

5. Method according to any one of the preceding claims, wherein the nanoparticles are produced by spark ablation.

6. Method according to any one of the preceding claims, wherein the steps are performed at atmospheric pressure.

7. Method according to any one of claims 3-6, wherein at least one of the vapors is an organic vapor, preferably selected from the group consisting of carboxylic acids, silanes, thiols, amines, peptides/proteins.

8. Method according to any one of the preceding claims, wherein before formation of the one or more shells, the nanoparticles are metallic nanoparticles.

9. Core/shell nanoparticle comprising a core surrounded by one or more shells, obtainable by the method according to any one of the preceding claims.

10. Core/shell nanoparticle according to claim 9, wherein
- at least one of the one or more shells is an organic shell; and/or
- the core/shell nanoparticle comprises a metallic core, surrounded by a first shell comprising a metal oxide adjacent to the metal core, surrounded by a second shell, wherein the second shell is preferably organic.

11. Core/shell nanoparticle according to claim 9 or 10, comprising a metallic zinc core, surrounded by a first shell comprising zinc oxide, and a second shell comprising ZIF-8.

12. Plurality of core/shell nanoparticles according to any one of claims 9-11, wherein the core/shell nanoparticles are spherical or spheroidal, preferably having an average particle diameter of 5-100 nm with a standard deviation of 10% or less.

13. System for producing core/shell nanoparticles, preferably using the method according to any one of claims 1-8, comprising a nanoparticle production unit, a collection chamber, and a conduit through which nanoparticles can be transported from the nanoparticle production unit to the collection chamber by a gas flow, the system further comprising one or more inlets for introducing reactive agents and/or vapors into the conduit.

14. System according to claim 13, wherein the nanoparticle production unit is a spark ablation generator.

15. System according to claim 13 or 14, further comprising a heatable vaporizer connected to one or more of the inlets.
